(19) **Europäisches Patentamt**

**European Patent Office**

**Office européen des brevets**

(11) **EP 0 948 132 B1**

(12) **EUROPEAN PATENT SPECIFICATION**

(45) Date of publication and mention
of the grant of the patent:
**26.05.2004 Bulletin 2004/22**

(51) Int Cl.⁷: $H03G\ 3/00$, H03G 1/00,
H03G 7/00

(21) Application number: **98830192.5**

(22) Date of filing: **31.03.1998**

(54) **Amplifier with programmable gain and input linearity usable in high-frequency lines**

Verstärker mit programmierbarer Verstärkungs- und Eingangslinearität für Hochfrequenzleitungen

Amplificateur à gain et linéarité d'entrée programmable utilisable dans des lignes à haute fréquences

(84) Designated Contracting States:
**DE FR GB IT**

(43) Date of publication of application:
**06.10.1999 Bulletin 1999/40**

(73) Proprietor: **STMicroelectronics S.r.l.**
**20041 Agrate Brianza (Milano) (IT)**

(72) Inventors:
• **Marchese, Stefano**
**27100 Pavia (IT)**
• **Pisati, Valerio**
**27040 Bosnasco (IT)**
• **Portaluri, Salvatore**
**27100 Pavia (IT)**

• **Savo, Alessandro**
**27100 Pavia (IT)**

(74) Representative: **Modiano, Guido, Dr.-Ing. et al**
**Modiano & Associati SpA**
**Via Meravigli, 16**
**20123 Milano (IT)**

(56) References cited:
**EP-A- 0 369 469**     **EP-A- 0 669 710**
**US-A- 5 589 791**

• **PATENT ABSTRACTS OF JAPAN vol. 095, no.**
**008, 29 September 1995 & JP 07 135432 A**
**(SHARP CORP), 23 May 1995,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates to an amplifier with programmable gain and input linearity usable in high-frequency lines.

Signal processing, for example for DVD (digital video disk), conventionally requires amplifiers which can be programmed with a wide gain range and high performance in terms of frequency.

A data read channel is an example of a case in which signal processing requires a gain-programmable amplifier.

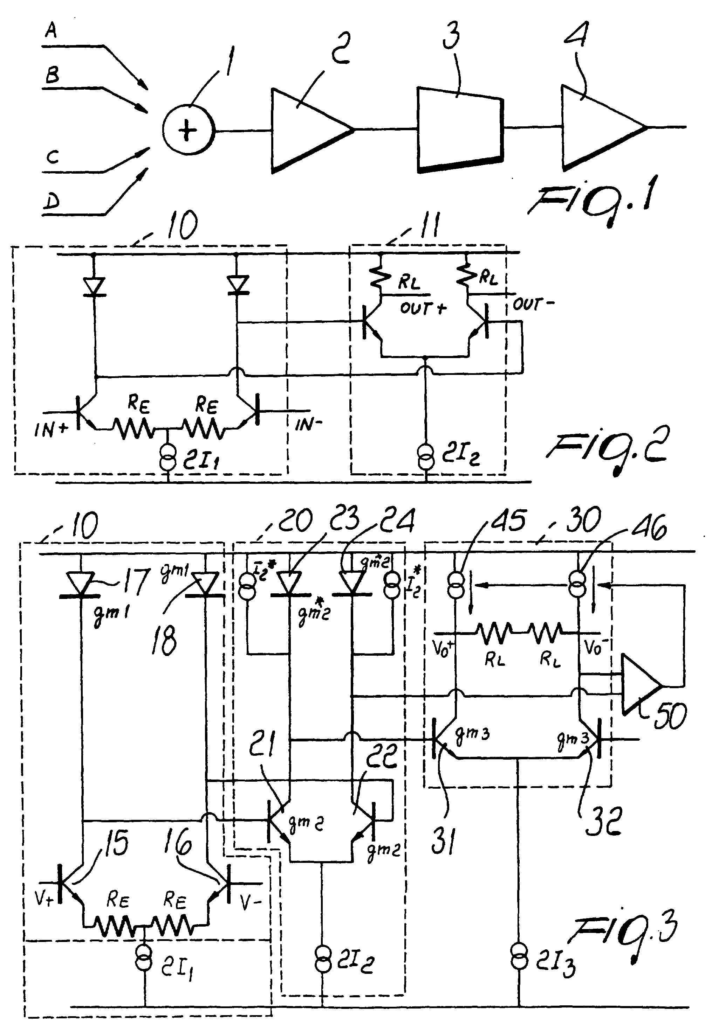

Figure 1 accordingly illustrates four signals A, B, C and D which have different amplitudes and are voltage-added in a node 1 and then amplified in gain means 2 which set the gain, so as to obtain a sum signal which is sent to equalizer means 3 and finally to a buffer 4.

The intended result is a dB-linear gain variation with a linear variation of the current.

A gain setting circuit of the prior art is shown in Figure 2, in which a differential input stage, designated by the reference numeral 10, is connected to a differential output stage, designated by the reference numeral 11, and in which the gain $A_V$ is determined by a resistance ratio multiplied by a current ratio. In practice, the resistance ratio is determined by the ratio between the resistances of the output stage with respect to those of the input stage, while the current ratio is the ratio between the current of the output stage and the current of the input stage.

Accordingly, the gain $A_V$ is determined by the following relation:

$$A_V = \frac{R_L}{R_E} \cdot \frac{I_2}{I_1}$$

The above-described circuit solution is effective as to gain programming, since said gain can be changed not only by varying the resistive ratio (which is difficult to implement and in any case entails large area occupation) but also by mainly varying the current ratio, which can be achieved easily with a modest utilization of the physical area of the device.

Although the circuit of Figure 2 is efficient as to gain programmability, it is affected by drawbacks due to the high noise that it has in output. The noise is in fact amplified by the current ratio between the output stage and the input stage and this entails a situation which is unacceptable whenever noise is an important negative factor.

EP-A-0 369 469 discloses a variable gain amplifier having a wider range wherein a gain can be controlled or varied.

Patent Abstracts of Japan vol. 095, no. 008, 29 September 1995 & JP 07 135432 A, 23 May 1995 disclose a variable gain amplifier.

The aim of the present invention is to provide an amplifier with programmable gain and input linearity usable in high-frequency lines and which allows to increase the gain without altering input linearity and without increasing current consumption excessively.

Within this aim, an object of the present invention is to provide an amplifier with programmable gain and input linearity, usable in high-frequency lines, in which the gain of the amplifier is closely correlated to current variation.

Another object of the present invention is to provide an amplifier with programmable gain and input linearity, usable in high-frequency lines, having high gain and high gain precision.

Another object of the present invention is to provide an amplifier with programmable gain and input linearity, usable in high-frequency lines, which is highly reliable, relatively easy to implement and at competitive costs.

This aim, these objects and others which will become apparent hereinafter are achieved by an amplifier with programmable gain and input linearity, as defined in appended claim 1.

Further characteristics and advantages of the invention will become apparent from the description of preferred but not exclusive embodiments of the programmable amplifier according to the invention, illustrated only by way of non-limitative example in the accompanying drawings, wherein:

Figure 1 is a conceptual diagram of a data read channel;
Figure 2 is a circuit diagram of a programmable amplifier implemented according to the prior art;
Figure 3 is a circuit diagram of a gain-programmable amplifier according to the present invention;
Figure 4 is a circuit diagram of a second embodiment of a gain-programmable amplifier according to the present invention; and
Figure 5 is a circuit diagram of another embodiment of the programmable amplifier according to the present invention.

The programmable amplifier according to the present invention is therefore described in detail with reference to Figures 3 to 5.

In particular, with reference to Figure 3, the circuit according to the invention comprises a first differential input stage 10 (similar to the differential input stage shown in Figure 2) composed of a first bipolar transistor 15 and of a second bipolar transistor 16, which are arranged so that their emitter terminals are connected to resistors $R_E$ and their collector terminals are connected to respective diodes 17 and 18.

A current source $2I_1$ is connected to the common point between the resistors $R_E$.

The first differential input stage (a differential stage is shown in this case, but the circuit according to the invention is equally valid if a single-input stage or a single-output output stage is used) is connected to at least one current amplifier stage, designated by the reference numeral 20, which is interposed between the differential input stage 10 and a differential output stage 30.

The current amplifier stage 20 is constituted by a first bipolar transistor 21 and by a second bipolar transistor 22 which have common-connected emitter terminals; a current source $2I_2$ is connected thereto. The base terminals of the bipolar transistors 21 and 22 are respectively connected to the collector terminals of the transistors 15 and 16, while voltage signals $V^+$ and $V^-$ are supplied to the base terminals of the transistors 15 and 16 of the first differential input stage.

The collector terminals of the transistors 21 and 22 are connected, respectively, to diodes 23 and 24 in which the anode terminal is connected to the collector terminal of the respective transistor.

Current sources $I_2^*$ are respectively parallel-connected to the diodes 23 and 24.

Finally, the second stage, i.e., the current amplifier stage 20, is connected to the output stage, which is also of the differential type (the same considerations made earlier apply to this case also) and is constituted by two transistors 31 and 32 in which the emitter terminals are common-connected and whereto a current source $2I_3$ is connected.

The collector terminals of the transistors 31 and 32 are respectively connected to resistors $R_L$.

The base terminals of the bipolar transistors 31 and 32 are respectively connected to the collector terminals of the transistors 21 and 22 of the current amplifier stage 20.

The above-described circuit has a gain which is given by:

$$A_V = \frac{R_L}{R_E} \cdot \frac{gm2}{gm1} \cdot \frac{gm3}{gm2^*}$$

from which:

$$A_V = \frac{R_L}{R_E} \cdot \frac{I_2}{I_1} \cdot \frac{I_3}{I_2 - I_2^*} = \frac{R_L}{R_E} \cdot \frac{I_3}{I_1} \cdot \frac{I_2}{I_2 - I_2^*}$$

The input stage 10 receives in input a pair of voltage signals and converts them into current signals, compressing them; said signals are sent to the second current amplifier stage 20, which amplifies the gain and then sends the signals thus amplified to the differential output stage 30, which converts the current signals back to voltage signals in order to have a voltage output.

It is also possible, of course, to have a current output, which is useful for example when applying filters etcetera.

The transconductance of the diodes 23 and 24 of the second current amplifier stage 20 can be modulated by varying the static current supplied by the sources $I_2^*$, which is independent of the current of the input stage 10.

Thus, by increasing the static current considerably, it is possible to increase the gain because transconductance decreases. Accordingly, a further degree of freedom to increase the gain is obtained in addition to the one provided by varying the currents of the differential input and output stages, i.e., the currents $I_1$ and $I_3$.

The current sources $I_2^*$ are therefore means for subtracting static current from the diodes 23 and 24 which thus allow to reduce the transconductances of the diodes 23 and 24.

It is thus possible to mutually cascade-connect a plurality of stages 20 between the differential input stage 10 and the differential output stage 30, so as to have a cascade of a plurality of gain factors provided by a current ratio in which the static current of the sources $I_2^*$ appears,

In the gain formula, gm1, gm2, gm3 and gm2* are, respectively, the transconductances of the diodes 17 and 18, of the transistors 21 and 22, of the diodes 23 and 24 and of the transistors 31 and 32.

Therefore, by varying the currents included in the gain formula it is possible to change the gain. In order to achieve high gain it is possible to have a small current $I_1$; however, a limit is set by input linearity (which is determined by $2I_1.R_E$). An alternative would be to increase the current $I_3$, but in this case the power dissipated by the circuit also increases.

Introducing the intermediate current amplifier stage 20 allows to increase gain without changing input linearity and without increasing current absorption excessively.

The term

$$\frac{I_2}{I_2 - I_2^*}$$

can be varied continuously or stepwise by changing the current $I_2^*$. The limit of the above-described structure consists in preventing the term $I_2 - I_2^*$ from becoming smaller than 0: in this case, the load diodes of the second stage 20, i.e., the diodes 23 and 24, switch off and the linear region is abandoned.

As mentioned, it is possible to introduce a plurality of stages like the one illustrated above in order to further increase the gain.

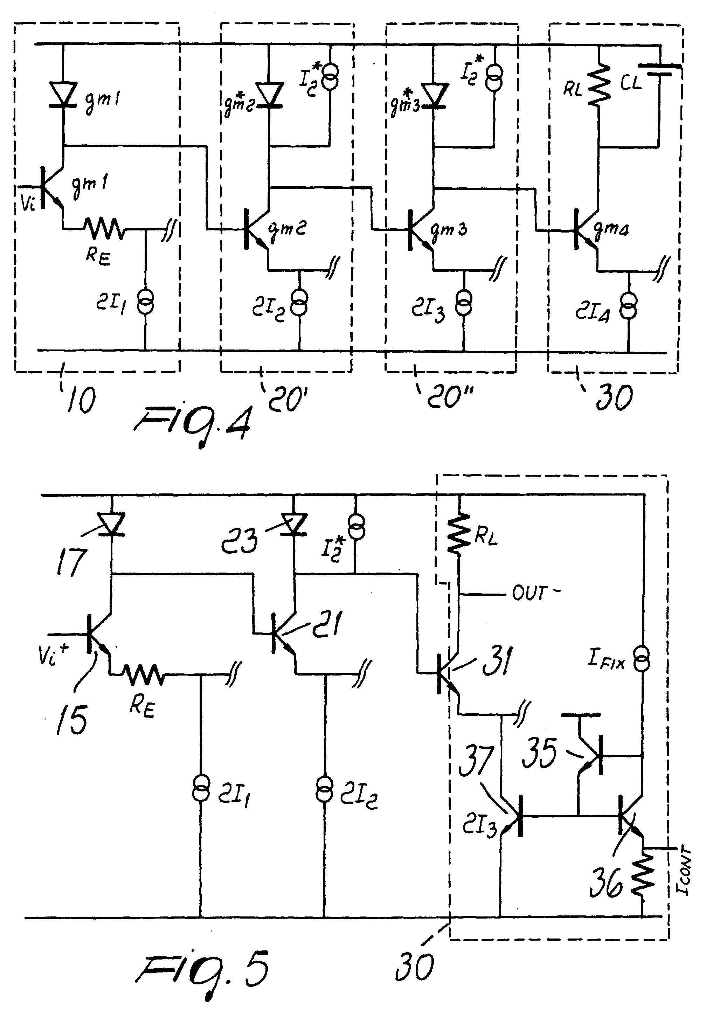

Figure 4 is a partial circuit diagram in which only one branch of the corresponding differential circuits is illustrated and the second branch is omitted; the diagram describes a circuit in which two current amplifier stages are interposed between the differential input stage 10 and the differential output stage 30; said amplifier stages are now designated by the reference numerals 20' and 20" and are provided according to the invention, like the stage 20 shown in Figure 3.

In this case, gm4 is the transconductance of the bipolar transistors of the output stage 30, while gm3 and gm3* are, respectively, the transconductances of the bipolar transistors and of the diodes of the second current amplifier stage 20".

Therefore, according to the circuit of Figure 4, the gain of the structure is:

$$AV = \frac{R_L}{R_E} \cdot \frac{gm2}{gm1} \cdot \frac{gm3}{gm2^*} \cdot \frac{gm4}{gm3^*}$$

from which:

$$A_V = \frac{R_L}{R_E} \cdot \frac{I_2}{I_1} \cdot \frac{I_3}{I_2 - I_2^*} \cdot \frac{I_4}{I_3 - I_3^*}$$

$$A_V = \frac{R_L}{R_E} \cdot \frac{I_4}{I_1} \cdot \frac{I_2}{I_2 - I_2^*} \cdot \frac{I_3}{I_3 - I_3^*}$$

If the currents are chosen so that their value is not very small, the output impedance of each stage is low and therefore the entire structure behaves like a single-pole amplifier which has a transfer function equal to:

$$H(S) = \frac{A_V}{1 + SR_L C_L}$$

The secondary poles are due to the impedance of the diodes and to the parasitic capacitors that occur on the respective nodes and are thus localized at high frequencies (this is true if the transconductance of the diodes is kept relatively high).

Figure 4 illustrates a capacitor $C_L$ representing a load capacitance due to a load which is connected to the amplifier according to the invention.

If the current $I_4$ of the differential output stage 30 is changed exponentially, it is possible to achieve dB-linear gain control.

The above-described circuit has also been used optimally at high frequencies.

The circuit shown in Figure 5 instead shows that the introduction of a control current $I_{cont}$ in the differential output stage allows to vary the current $2I_3$ exponentially by varying it in a linear fashion; accordingly, in this case the gain of the amplifier also varies exponentially.

In practice, the differential output stage 30 is formed, in this case, by a modified current mirror, as shown in Figure 5, in which an additional bipolar transistor 35 is provided which is connected, by means of its base terminal, to the collector terminal of a transistor 36 which receives, on its emitter terminal, a control current $I_{cont}$ and is connected to the transistor 37 by means of its base terminal.

If the current $I_3$ varies in order to change the gain, the common-mode voltage in output from the stage 30 changes; accordingly, it can be useful to have a common-mode circuit, designated by the reference numeral 50 and shown in Figure 3. Said common-mode circuit is an amplifier which has a reference voltage and receives in input the voltages received on the collectors of the transistors 31 and 32 and provides feedback control in output of current sources 45 and 46.

The amplifier thus controls the half-sum of the inputs taken from the collectors of the transistors 31 and 32 and compares said half-sum with the reference voltage in order to generate an error signal and control the current sources 45 and 46. The half-sum of the voltages in input to the common-mode circuit 50 must be equal to the reference voltage. In this case, the circuit 50 performs no action on the current sources 45 and 46.

In practice it has been observed that the programmable amplifier according to the invention fully achieves the intended aim and objects, since it allows to program the gain while maintaining input linearity.

It is also possible to achieve a high gain with high precision of said gain simultaneously with high performance in terms of frequency. This is due to the fact that frequency compensation is simpler than a circuit solution in which a cascade of voltage-gain stages is present, because all of the secondary poles are associated with low impedances and therefore with a high frequency (low impedances can be achieved because it is not necessary to provide voltage gain in the internal nodes of the circuit).

Finally, the circuit according to the invention achieves low power dissipation and can have a current output, which is useful for applying for example filters etcetera.

The amplifier thus conceived is susceptible of numerous modifications and variations, all of which are within the scope of the inventive concept; all the details may also be replaced with other technically equivalent elements.

In practice, the materials employed, so long as they are compatible with the specific use, as well as the dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. An amplifier with programmable gain and input linearity, comprising:

an input stage (10), which is suitable to receive a voltage signal (V$^+$, V$^-$) and perform current conversion thereof with compression;

an output stage (30), which is connected to the input stage (10) and is suitable to decompress the signal in output from said input stage, producing gain amplification thereof;

at least one current amplifier stage (20) which is interposed between said input stage (10) and said output stage (30) and comprises at least one bipolar transistor (21, 22) which is series-connected to a load diode (23, 24) and to a current source (2I$_2$);

programmable means (I$_2$, I$_2$*) for reducing the transconductance of said load diode (23, 24) being provided in said at least one amplifier stage (20) to determine a programmable amplification factor for the gain of said amplifier, said programmable means comprising a static current source which is parallel-connected to said load diode;

in said at least one current amplifier stage interposed between said input stage and said output stage, said static current source, together with said current source, producing an amplification factor for the gain of said amplifier which can be programmed by varying the value of said static current source.

2. The amplifier according to claim 1, **characterized in that** said input stage (10), said output stage (30) and said at least one current amplifier stage (20) are differential stages.

3. The amplifier according to claim 2, **characterized in that** said differential output stage (30) is connected to a common-mode feedback circuit (50) which receives in input the differential voltage signals in output from said output stage (30) and compares them with a reference voltage in order to generate a signal for driving a pair of current sources which are respectively parallel-connected to load resistors of said output stage.

4. The amplifier according to claim 3, **characterized in that** said differential input stage (10) comprises two transistors (15, 16) which are arranged in a mirror configuration and in which corresponding load diodes (17, 18) are connected to the collector terminals, said collector terminals being connected to the base terminals of a pair of transistors (21, 22) of said at least one current amplifier stage.

5. The amplifier according to claim 4, **characterized in that** said differential input stage (10) comprises two resistors (R$_E$) which are respectively connected to the emitter terminals of said pair of transistors of the differential input stage.

## Patentansprüche

1. Verstärker mit programmierbarer Verstärkungs- und Eingangslinearität, mit:

einer Eingangsstufe (10), die geeignet ist, ein Spannungssignal (V$^+$, V$^-$) zu empfangen und eine Stromwandlung mit Kompression durchzuführen;

einer Ausgangsstufe (30), die an die Eingangsstufe (10) angeschlossen und geeignet ist, das Signal im Ausgang von der Eingangsstufe zu dekomprimieren, um deren Verstärkungsfaktor zu erzeugen;

mindestens einer Stromverstärkerstufe (20), die zwischen der Eingangsstufe (10) und der Ausgangsstufe (30) geschaltet ist und mindestens einen bipolaren Transistor (21, 22) aufweist, der mit einer Lastdiode (23, 24) und einer Stromquelle (2I$_2$) in Reihe geschaltet ist;

Programmiermittel (I$_2$, I$_2$*) zur Reduktion des Gegenwirkleitwertes der Lastdiode (23, 24), welche in mindestens einer Verstärkerstufe (20) vorgesehen ist, um einen programmierbaren Verstärkungsfaktor für die Verstärkung des Verstärkers zu ermitteln, wobei die programmierbaren Mittel eine statische Stromquelle aufweisen, die zur Lastdiode parallel geschaltet ist;

wobei in mindestens einer Stromverstärkerstufe, die zwischen der Eingangsstufe und der Ausgangsstufe zwischengeschaltet ist, die statische Stromquelle zusammen mit der Stromquelle einen Verstärkungsfaktor für die Verstärkung des Verstärkers erzeugt, der durch Veränderung des Wertes der statischen Stromquelle programmiert werden kann.

2. Verstärker nach Anspruch 1, **dadurch gekennzeichnet, dass** die Eingangsstufe (10), die Ausgangsstufe (30) und die mindestens eine Stromverstärkerstufe (20) Differentialstufen sind.

3. Verstärker nach Anspruch 2, **dadurch gekennzeichnet, dass** die Differentialausgangsstufe (30) an eine Common-Mode-Rückkoppelungsschaltung (50) angeschlossen ist, die an ihrem Eingang die Differentialspannungssignale vom Ausgang der Ausgangsstufe (30) empfängt und diese mit einer Referenzspannung vergleicht, um ein Signal zu erzeugen, um ein Paar von Stromquellen zu treiben, die jeweils zu Lastwiderständen der Ausgangsstufe parallel geschaltet sind.

4. Verstärker nach Anspruch 3, **dadurch gekennzeichnet, dass** die Differentialeingangsstufe (10) zwei Transistoren (15, 16) aufweist, die in einer Spiegelbildanordnung verschaltet sind, und wobei entsprechende Lastdioden (17, 18) an die Kollektoranschlüsse angeschlossen sind, wobei die Kollektoranschlüsse an die Basisanschlüsse eines Paares von Transistoren (21, 22) der mindestens einen Stromverstärkerstufe angeschlossen sind.

**5.** Verstärker nach Anspruch 4,
**dadurch gekennzeichnet, dass** die Differentialeingangsstufe (10) zwei Widerstände ($R_E$) aufweist, die jeweils an die Emitteranschlüsse des Paares der Transistoren der Differentialeingangsstufe angeschlossen sind.

**Revendications**

**1.** Amplificateur à gain programmable et entrée linéaire, comprenant :

un étage d'entrée (10) propre à recevoir un signal de tension ($V^+$, $V^-$) et à réaliser une conversion en courant de celui-ci, avec une compression ;
un étage de sortie (30) connecté à l'étage d'entrée (10) et propre à décomprimer le signal en sortie en provenance de l'étage d'entrée, produisant une amplification de celui-ci ;
au moins un étage amplificateur de courant (20) interposé entre l'étage d'entrée (10) et l'étage de sortie (30) et comprenant au moins un transistor bipolaire (21, 22) connecté en série avec une diode de chargé (23, 24) et une source de courant ($2I_2$);
un moyen programmable ($I_2$, $I_2^*$) pour réduire la transconductance de la diode de charge (23, 24) étant prévu dans ledit au moins un étage amplificateur (20) pour déterminer un facteur d'amplification programmable pour le gain de l'amplificateur, le moyen programmable comprenant une source de courant statique qui est connectée en parallèle sur la diode de charge ;
dans ledit au moins un étage amplificateur de courant interposé entre l'étage d'entrée et l'étage de sortie, la source de courant statique produisant, avec ladite source de courant, un facteur d'amplification pour le gain de l'amplificateur qui peut être programmé en modifiant la valeur de la source de courant statique.

**2.** Amplificateur selon la revendication 1, **caractérisé en ce que** l'étage d'entrée (10), l'étage de sortie (30) et ledit au moins un étage amplificateur de courant (20) sont des étages différentiels.

**3.** Amplificateur selon la revendication 2, **caractérisé**

**en ce que** l'étage de sortie différentiel (30) est connecté à un circuit de réaction de mode commun (50) qui reçoit les signaux de tension différentiels provenant de l'étage de sortie (30) et les compare à une tension, de référence pour produire un signal pour piloter deux sources de courant qui sont respectivement connectées en parallèle à des résistances de charge de l'étage de sortie.

**4.** amplificateur selon la revendication 3, **caractérisé en ce que** l'étage d'entrée différentiel (10) comprend deux transistors (15, 16) qui sont disposés en une configuration de miroir, des diodes de charge correspondantes (17, 18) étant connectées aux bornes de collecteur, les bornes de collecteur étant connectées aux bornes de base de deux transistors (21, 22) dudit au moins un étage amplificateur de courant.

**5.** Amplificateur selon la revendication 4, **caractérisé en ce que** l'étage d'entrée différentiel (10) comprend deux résistances ($R_E$) qui sont respectivement connectées aux bornes d'émetteur des deux transistors de l'étage d'entrée différentiel.

Fig.1

Fig.2

Fig.3

Fig.4

Fig.5